# EUROPEAN PATENT APPLICATION

(11) **EP 4 572 552 A1**
(43) Date of publication of application: **18.06.2025**
(21) Application number: 23923631.8
(22) Date of filing: 19.07.2023
(51) Int. Cl.: H05K 7/20

(54) **SPECIAL-SHAPED HEAT DISSIPATION DEVICE**

(30) Priority: 24.02.2023 CN 202320333514 U
(71) Applicant: Guangdong Envicool Technology Co., Ltd., Sanjiao Town, Zhongshan Guangdong 528400 (CN)
(72) Inventor: TU, Yijian, Zhongshan, Guangdong 528400 (CN); ZHANG, Jing, Zhongshan, Guangdong 528400 (CN); CHEN, Qiaolong, Zhongshan, Guangdong 528400 (CN)
(74) Representative: Potter Clarkson
(86) International application number: PCT/CN2023/108094
(87) International publication number: WO 2024/174463

(57) **Abstract**

A special-shaped heat dissipation device comprises: a substrate (1), a cover board (2) attached to the substrate (1), and fins (3) provided on the cover board (2); the substrate (1) is connected to the cover board (2) to constitute an accommodating cavity allowing a working medium to flow, the side of the substrate (1) away from the cover board (2) can be connected to a heat source (4), snap-fit slots are provided on the side of the cover board (2) away from the substrate (1), the fins (3) are inserted into the snap-fit slots, a gas-liquid cavity is formed in each fin (3), and the gas-liquid cavity is communicated with the accommodating cavity, wherein heat dissipation columns (5) with at least two sizes are provided in the gas-liquid cavity, there are a plurality of heat dissipation columns (5) of each size, and the heat dissipation columns (5) with at least two sizes are distributed in a staggered manner. The special-shaped heat dissipation device is based on phase change heat transfer. By arranging the heat dissipation columns (5) with different sizes in a staggered manner in the fins (3), turbulent flow of the working medium can be realized in the fins (3), result in higher heat transfer efficiency. The special-shaped heat dissipation device possesses a stronger heat dissipation capability than traditional heat sinks, and can address the evolving heat dissipation demands of electronic devices in the communications industry.

## Description

This application claims the priority to Chinese Patent Application No. 202320333514.3, titled "SPECIAL-SHAPED HEAT DISSIPATION DEVICE", filed on February 24, 2023 with the China National Intellectual Property Administration, which is incorporated herein by reference in its entirety.

### FIELD

The present application relates to the technical field of heat dissipation for electronics, and in particular to a special-shaped heat dissipation device.

### BACKGROUND

At present, most of communication devices dissipate heat by using a low-power heat dissipation device such as a traditional shovel tooth, an aluminum extrusion (aluminum-extrusion type heat dissipation member) plus heat pipe, an aluminum extrusion plus VC (Vapor Chamber) and the like. In the implementation of the present application, it is found that there are at least following problems existing in the conventional technology.

With the upgrading of the communication devices from generation to generation, heat dissipation requirements for the communication devices increase. However, the heat dissipation device has a short heat transmission distance and low heat dissipation power, which cannot meet the heat dissipation requirements for the upgraded communication devices, especially the heat dissipation requirements for electronic devices used in the current 5G communication industry.

In summary, how to deal with the heat dissipation requirements for the upgraded electronic devices in the communication industry has attracted attention of those skilled in the art.

### SUMMARY

In view of this, an object of the present application is to provide a special-shaped heat dissipation device, which can improve the problem of the heat dissipation requirements for upgraded electronic devices in the current communication industry.

In order to achieve the above object, the following technical solutions are provided according to the present application.

A special-shaped heat dissipation device includes a base plate, a cover plate attached to the base plate, and a fin arranged on the cover plate. The base plate and the cover plate are connected with each other to form an accommodating cavity for phase-changed working medium to flow, one side of the base plate away from the cover plate is configured to be connected to a heat source, and a clamping slot is provided on one side of the cover plate away from the base plate. The fin is inserted into the clamping slot, and a gas-liquid cavity in communication with the accommodating cavity is formed in the fin.

The gas-liquid cavity is internally provided with heat dissipation columns with at least two different sizes, where the number of the heat dissipation columns with each of the at least two different sizes is plural, and the heat dissipation columns with the at least two different sizes are distributed in a staggered manner as a whole.

In an embodiment, the heat dissipation columns with at least two different sizes gradually increase in size from a first side of the fin to a second side opposite to the first side, and an interval between the heat dissipation columns in two different rows gradually increases from the first side of the fin to the second side opposite to the first side.

In an embodiment, multiple clamping slots are provided on one side of the cover plate away from the base plate, and multiple fins are correspondingly provided.

In an embodiment, a groove is formed in the base plate, and multiple reinforcing columns distributed in a matrix are arranged in the groove.

In an embodiment, a flow-blocking wall is formed in the base plate, and multiple through holes are arranged in the flow-blocking wall. The clamping slot of the cover plate is provided with a first channel for circulating gaseous working medium and a second channel for circulating liquid working medium, where the first channel is arranged corresponding to a first side of the flow-blocking wall, the second channel is arranged corresponding to a second side of the flow-blocking wall, and channel ports are formed at positions of the fin corresponding to the first channel and the second channel respectively.

In an embodiment, the base plate includes a first base body and a second base body, and the cover plate includes a first cover member for circulating liquid working medium and a second cover member for circulating gaseous working medium. The first cover member is arranged corresponding to the first base body, the second cover member is arranged corresponding to the second base body, and channel ports are formed at positions of the fin corresponding to the first cover member and the second cover member respectively.

In an embodiment, the first base body is connected to the second base body through a pipeline.

In an embodiment, the special-shaped heat dissipation device further includes a protection plate, where the fin is fixed to the protection plate by welding.

In an embodiment, multiple holes are formed in the protection plate, and
each of the multiple holes is a regular quadrangular hole, a regular pentagonal hole, a regular hexagonal hole or a circular hole.

In an embodiment, the base plate, the cover plate and the fin are formed to be an integrated brazed structural member, and
each of the heat dissipation columns is a cylinder, a regular triangular column, a regular quadrangular column, a regular pentagonal column or a regular hexagonal column.

In a process of using the special-shaped heat dissipation device according to the present application, when the heat source starts to work, the phase-changed working medium in the accommodating cavity absorbs heat generated by the heat source, and the working medium undergoes a phase change reaction and vaporizes. The vaporized working medium enters the gas-liquid cavity of the fin from the accommodating cavity. Since the gas-liquid cavity is internally provided with the heat dissipation columns which have different sizes and are distributed in the staggered manner as a whole, the working medium can realize turbulence flow in the gas-liquid cavity, thereby reducing the vaporization resistance of the working medium and improving a liquefaction rate of the working medium. In addition, since the heat dissipation columns are distributed in the staggered manner as a whole, formed flow passages are more complicated, and the working medium flows through surfaces of the heat dissipation columns in a more sufficient way, so that the heat exchange area is increased and the working medium can transfer heat and exchange heat more sufficiently, thereby ensuring the smooth exchange between the gaseous working medium and the liquid working medium and more sufficient heat dissipation. That is, the special-shaped heat dissipation device according to the present application performs heat exchange based on the phase change. By provision of the heat dissipation columns with different sizes to be distributed in the staggered manner as a whole in the fin, the working medium can realize turbulence flow in the fin, and the heat exchange efficiency is higher, thereby enabling better heat dissipation performance than the conventional heat dissipation device, and further improving the problem of the heat dissipation requirements for upgraded electronic devices in the communication industry.

In summary, the special-shaped heat dissipation device according to the present application has better heat dissipation performance, and can improve the problem of the heat dissipation requirements for upgraded electronic devices in the current communication industry.

### BRIEF DESCRIPTION OF THE DRAWINGS

For more clearly illustrating technical solutions in embodiments of the present application or in the conventional technology, the drawings referred to for describing the embodiments or the conventional technology will be briefly described hereinafter. Apparently, the drawings in the following description illustrate only some embodiments of the present application, and other drawings may be obtained by those skilled in the art based on the provided drawings without any creative efforts.
FIG. 1 is a schematic structural view of a special-shaped heat dissipation device according to the present application;
FIG 2 is a schematic structural view of a fin;
FIG. 3 is a schematic structural view of a base plate;
FIG. 4 is a schematic view showing a working principle of the special-shaped heat dissipation device shown in FIG. 1;
FIG. 5 is a schematic structural view of a special-shaped heat dissipation device according to another embodiment;
FIG. 6 is a schematic view showing a working principle of the special-shaped heat dissipation device shown in FIG. 5;
FIG. 7 is a schematic structural view of a base plate according to another embodiment;
FIG. 8 is a schematic structural view of a special-shaped heat dissipation device according to yet another embodiment; and
FIG. 9 is a schematic view showing a working principle of the special-shaped heat dissipation device shown in FIG. 8.

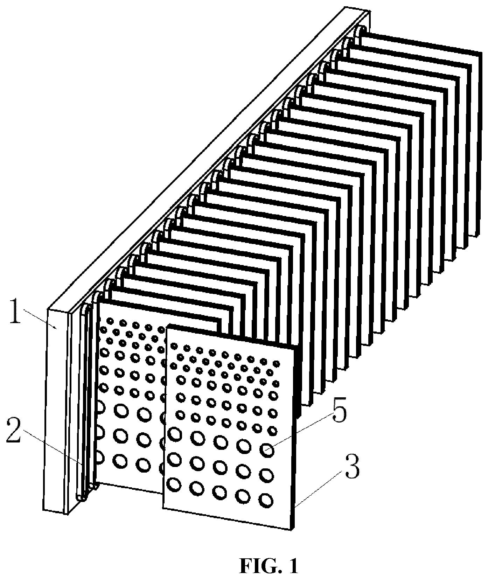

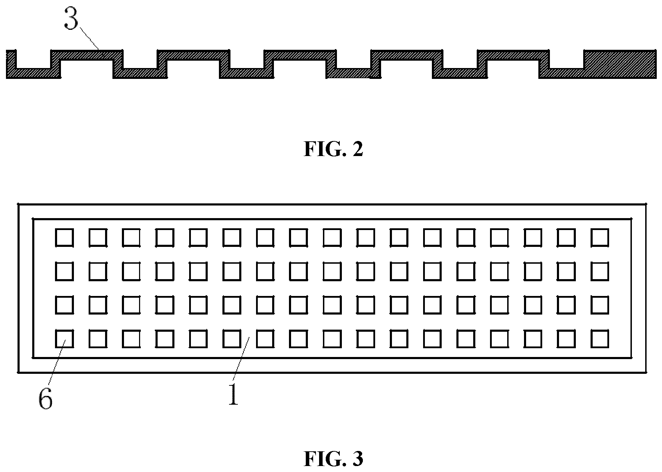

Reference numerals in FIGS. 1 to 9 are listed as follows:
1 base plate; 2 cover plate; 3 fin; 4 heat source; 5, heat dissipation column; 6 reinforcing column; 7 flow-blocking wall; 8 through hole; 9 first channel; 10 second channel; 11 channel port; 12 first base body; 13 second base body; 14 first cover member; 15 second cover member; 16 pipeline; 17 protection plate; 18 hole; 19 steam path; 20 liquid return path; A fin upper portion; B fin lower portion.

### DETAILED DESCRIPTION OF THE EMBODIMENTS

Technical solutions in embodiments of the present application are clearly and completely described hereinafter in conjunction with the drawings of the embodiments of the present application. Apparently, the embodiments described hereinafter are only some embodiments of the present application, rather than all embodiments. Based on the embodiments in the present application, all of the other embodiments obtained by those skilled in the art without any creative efforts fall within the protection scope of the present application.

A core of the present application is to provide a special-shaped heat dissipation device, which can improve the problem of the heat dissipation requirements for upgraded electronic devices in the current communication industry.

Reference is made to FIGS. 1 to 9.

A special-shaped heat dissipation device is provided according to an embodiment of the present application. The special-shaped heat dissipation device includes a base plate 1, a cover plate 2 attached to the base plate 1, and a fin 3 arranged on the cover plate 2.

The base plate 1 and the cover plate 2 are connected with each other to form an accommodating cavity for working medium to flow, that is, the base plate 1 and the cover plate 2 form an accommodating cavity which may accommodate the working medium and allow the working medium to flow. It can be understood that the working medium accommodated in the accommodating cavity is a phase-change working medium, which can perform heat exchange based on phase change, so as to improve a heat dissipation performance of the heat dissipation device.

One side of the base plate 1 away from (or facing away form) the cover plate 2 is configured to be connected to a heat source 4, that is, the heat source 4 may be mounted on one side of the base plate 1 away from the cover plate 2. A clamping slot for accommodating the fin 3 is provided on one side of the cover plate 2 away from the base plate 1.

The fin 3 is inserted into the clamping slot, that is, the fin 3 is arranged on the cover plate 2 through an insertion connecting manner. A gas-liquid cavity in communication with the accommodating cavity is formed in the fin 3. The gas-liquid cavity is internally provided with heat dissipation columns 5 with three different sizes, where the number of the heat dissipation columns 5 with each of the three different sizes may be plural, and the heat dissipation columns 5 with the three different sizes are distributed in a staggered manner as a whole. It can be understood that the clamping slot is in communication with the accommodating cavity, so that the gas-liquid cavity formed in the fin 3 inserted into the clamping slot can be communicated with the accommodating cavity. That is, the fin 3 has an opening which is in communication with the gas-liquid cavity and the accommodating cavity, so that the gaseous working medium which is phase-changed by absorbing heat in the accommodating cavity can enter the gas-liquid cavity through the opening of the fin 3, and the liquid working medium which is liquefied in the gas-liquid cavity can flow back into the accommodating cavity through the opening of the fin 3, thereby realizing a circulation of the working medium.

It should be noted that, the heat dissipation columns 5 with a same size are generally arranged in a same region to facilitate processing. Moreover, in other embodiments, the gas-liquid cavity may be internally provided with the heat dissipation columns 5 with two different sizes. The number of the heat dissipation columns with each of the two different sizes may be plural, and the heat dissipation columns 5 with the two different sizes are distributed in a staggered manner as a whole. Although this arrangement is not shown in drawings, those skilled in the art can clearly know how to realize this arrangement with reference to FIGS. 1 to 9. Alternatively, the gas-liquid cavity may be internally provided with the heat dissipation columns 5 with four different sizes. The number of the heat dissipation columns with each of the four different sizes may be plural, and the heat dissipation columns 5 with the four different sizes are distributed in a staggered manner as a whole. Although this arrangement is not shown in drawings either, those skilled in the art can clearly know how to realize this arrangement with reference to FIG. 1 to FIG. 9. Alternatively, the gas-liquid cavity may be internally provided with the heat dissipation columns 5 with more than four different sizes, which will not be repeated and limited herein. That is to say, in the special-shaped heat dissipation device according to the present application, the gas-liquid cavity of the fin 3 is internally provided with the heat dissipation columns 5 with at least two different sizes, where the number of the heat dissipation columns with each of the at least two different sizes may be plural, and the heat dissipation columns 5 with the at least two different sizes are distributed in a staggered manner as a whole. Specifically, the heat dissipation columns 5 may be arranged as follows.
1. The heat dissipation columns 5 with the same size are distributed in a matrix, and the heat dissipation columns 5 with different sizes are distributed in a staggered manner, so that the heat dissipation columns 5 with at least two different sizes are distributed in the staggered manner as a whole.
2. The heat dissipation columns 5 with the same size are distributed in the staggered manner, and the heat dissipation columns 5 with different sizes are also distributed in the staggered manner, so that the heat dissipation columns 5 with at least two different sizes are distributed in the staggered manner as a whole.
3. The heat dissipation columns 5 with the same size are distributed in the staggered manner, and the heat dissipation columns 5 with different sizes are distributed in a matrix, so that the heat dissipation columns 5 with at least two different sizes are distributed in the staggered manner as a whole.

The arrangement of the heat dissipation columns 5 is not particularly limited, as long as the heat dissipation columns 5 are distributed in the staggered manner as a whole.

In an embodiment, multiple clamping slots are provided on one side of the cover plate 2 away from (or facing away from) the base plate 1, and multiple fins 3 are correspondingly provided. Each of the fins 3 is inserted into a corresponding clamping slot. The fin 3 is arranged perpendicular to the cover plate 2. Of course, in other embodiments, the fin 3 may not be arranged perpendicular to the cover plate 2, that is, an included angle formed between the fin 3 and the cover plate 2 may not be a right angle. How to mount the fin 3 to the cover plate 2 is not specifically limited in the present application, as long as it can meet the requirements.

It should be noted that the number of fins 3 and the clamping slots for accommodating the fins 3 may be flexibly adjusted as required. The fin 3 is formed by two plates connected with each other. The two plates may be stamping processed by a mature stamping process, so that multiple support column structures are formed on the plates, and the two plates and support column structures formed on the two plates are correspondingly welded together to form the fin 3. That is, the fin 3 is manufactured by a low-cost and mature stamping process, which can reduce the manufacturing cost of the device.

Shapes, structures, dimensions and materials of the base plate 1, the cover plate 2 and the fin 3 may be determined according to the actual situation and actual needs in the actual application process.

Moreover, the heat dissipation fin of the special-shaped heat dissipation device is adjustable based on the actual situations and requirements. For example, in some situations with lower heat dissipation requirements, it is possible to use some solid fins to replace some of the fins 3 in the special-shaped heat dissipation device, which can not only meet the heat dissipation requirements, but also reduce the cost.

The special-shaped heat dissipation device according to the present application is generally placed vertically, that is, mounted along a direction of gravity, or placed at a certain angle, for example, 5 degrees, to a vertical direction. The angel cannot be too large, otherwise the normal use of the heat dissipation device will be affected. The special-shaped heat dissipation device may be mounted based on the actual situations and actual requirements in the actual application process. In a process of using the special-shaped heat dissipation device according to the present application, the working medium in the accommodating cavity absorbs heat generated by the heat source 4, and the working medium undergos a phase change reaction and vaporizes. The vaporized working medium (i.e. steam) enters the gas-liquid cavity of the fin 3 from the accommodating cavity. Since the gas-liquid cavity is internally provided with the heat dissipation columns 5 which have different sizes and are distributed in the staggered manner as a whole, the working medium can realize turbulence flow in the gas-liquid cavity, thereby reducing the vaporization resistance of the working medium and improving a liquefaction rate of the working medium. In addition, since the heat dissipation columns 5 in the gas-liquid cavity are distributed in the staggered manner as a whole, formed flow passages are more complicated, and the working medium flows through surfaces of the heat dissipation columns 5 in a more sufficient way, so that the heat exchange area is increased and the working medium can transfer heat and exchange heat more sufficiently, thereby ensuring the smooth exchange between the gaseous working medium and the liquid working medium and more sufficient heat dissipation. That is, the special-shaped heat dissipation device according to the present application performs heat exchange based on the phase change. By provision of the heat dissipation columns 5 with different sizes to be distributed in the staggered manner as a whole in the fin 3, the working medium can realize turbulence flow in the fin 3, and the heat exchange efficiency is higher, thereby enabling better heat dissipation performance than the conventional heat dissipation device, and further improving the problem of the heat dissipation requirements for upgraded electronic devices in the communication industry.

In summary, the special-shaped heat dissipation device according to the present application has better heat dissipation performance, and can improve the problem of the heat dissipation requirements for upgraded electronic devices in the current communication industry.

On the basis of the above embodiments, it is preferable that the base plate 1, the cover plate 2 and the fins 3 are formed to be an integrated brazed structural member. After the base plate 1 and the cover plate 2 are attached to each other, multiple fins 3 may be inserted into respective clamping slots. After all of the components are assembled, the whole structure is brazed in a tunnel furnace to form the integrated brazed structural member.

In an embodiment, the heat source 4 is arranged at a first part of the base plate 1. In this embodiment, the first part of the base plate 1 is a lower region of the base plate 1, that is, the heat source 4 is arranged at the lower region of the base plate 1.

In an embodiment, the heat dissipation columns 5 with different sizes gradually increase in size from a first side of the fin 3 to a second side opposite to the first side, that is, the size of the heat dissipation columns 5 gradually increases from the first side of the fin 3 to the second side opposite to the first side, and an interval between the heat dissipation columns 5 in two different rows gradually increases from the first side of the fin 3 to the second side opposite to the first side. In this embodiment, the first side of the fin 3 is an upper side of the fin 3, and the second side is a lower side of the fin 3. That is, the heat dissipation columns 5 with different sizes gradually increase in size from the upper side to the lower side of the fin 3, and the interval between the heat dissipation columns 5 in two different rows gradually increases from the upper side to the lower side of the fin 3. That is, the heat dissipation columns 5 on the upper side of the fin 3 are small in size and densely distributed, while the heat dissipation columns 5 on the lower side of the fin 3 are large in size and sparsely distributed.

It should be noted that when the heat source 4 starts to work, the working medium that absorbs the heat from the heat source 4 and undergoes phase change vaporization can enter the gas-liquid cavity of the fin 3 from the accommodating cavity. Since the gas-liquid cavity is internally provided with the heat dissipation columns 5 which have different sizes and are distributed in the staggered manner as a whole, the working medium can realize turbulence flow in the gas-liquid cavity, thereby reducing the vaporization resistance of the working medium and improving a liquefaction rate of the working medium. Moreover, since the heat dissipation columns 5 in the gas-liquid cavity are distributed in the staggered manner as a whole, flow passages formed in the gas-liquid cavity are more complicated, the working medium can flow through surfaces of the heat dissipation columns 5 in a more sufficient way to achieve sufficient heat exchange and heat transmission, The gaseous working medium is vaporized upward, so that there is more gas and less liquid at a bottom portion and there is more liquid and less gas at a top portion. Therefore, the air pressure at a lower part of the fin 3 is large and the air pressure at an upper part is small. The lower heat dissipation columns 5 are large in size and the flow passages are sparsely distributed, while the upper heat dissipation columns 5 are small in size and the flow passages are densely distributed, thereby realizing a phase-change balance between the gas phase and the liquid phase, a smooth exchange of the gas and the liquid, and sufficient heat dissipation. Moreover, the arrangement of the heat dissipation columns 5 can not only increase the heat exchange area, but also support the gas-liquid cavity of the fin 3 and improve the strength of the fin 3, so as to avoid a depression at a position of the fin 3 corresponding to the gas-liquid cavity.

In an embodiment, the heat dissipation column 5 may be a cylinder, a regular triangular column, a regular quadrangular column, a regular pentagonal column or a regular hexagonal column. Column structures with different sizes are arranged in the cavity of the fin 3 in the staggered manner as a whole, so that the phase-change heat exchange efficiency of the working medium in the fin 3 is higher, and the size, shape, number and position of the heat dissipation columns 5 can be determined based on the actual heat dissipation requirements.

In an embodiment, a groove is formed in the base plate 1, and multiple reinforcing columns 6 distributed in a matrix are arranged in the groove. That is, the base plate 1 may be internally reinforced by the reinforcing columns 6 with same size to improve the structural strength. Only one cavity is formed in the base plate 1. Both the gaseous working medium and the liquid working medium exist in the cavity. Once the base plate 1 is connected to the cover plate 2, the cavity and the cover plate enclose the accommodation cavity, and a flow passage is formed between each two adjacent ones of the reinforcing columns 6 in the cavity.

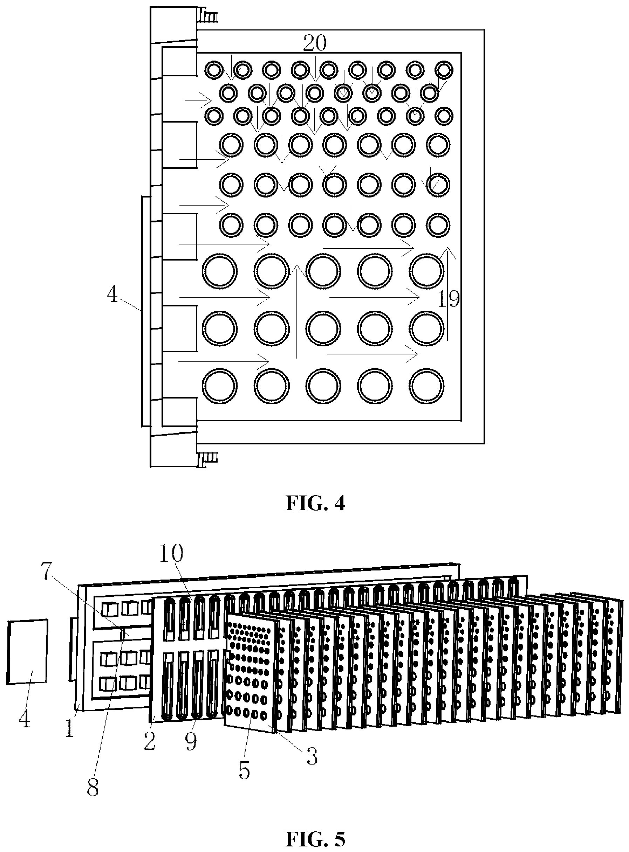

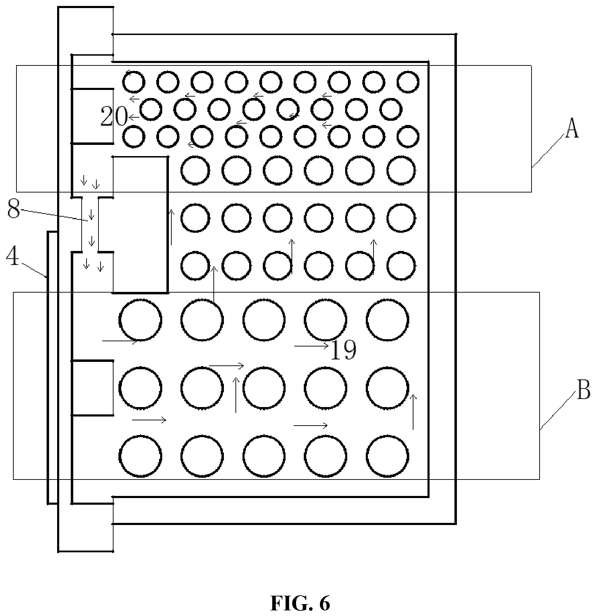

In an embodiment, a flow-blocking wall 7 is formed in the base plate 1, and the groove in the base plate 1 may be separated into two portions by the flow-blocking wall 7. Multiple through holes 8 are arranged in the flow-blocking wall 7, so that the two portions separated by the flow-blocking wall 7 can be communicated with each other. The clamping slot of the cover plate 2 is formed with a first channel 9 for circulating gaseous working medium and a second channel 10 for circulating liquid working medium. The first channel 9 is arranged corresponding to a first side of the flow-blocking wall 7, and the second channel 10 is arranged corresponding to a second side of the flow-blocking wall 7. In this embodiment, the first side of the flow-blocking wall 7 is a lower side of the flow-blocking wall 7, and the second side of the flow-blocking wall 7 is an upper side of the flow-blocking wall 7. That is, the first channel 9 is arranged corresponding to the lower side of the flow-blocking wall 7, and the second channel 10 is arranged corresponding to the upper side of the flow-blocking wall 7. Channel ports 11 are formed at positions of the fin 3 corresponding to the first channel 9 and the second channel 10 respectively. The structure of the channel ports 11 is shown in FIG. 5, and a flow process of the gaseous working medium and the liquid working medium is shown in FIG. 6, in which a flowing direction of the working medium is indicated by arrows.

It should be noted that by provision of the flow-blocking wall 7 in the base plate 1, the gaseous working medium generated by vaporization in the accommodating cavity due to the phase change reaction can be prevented from directly entering the second channel 10 from the upper portion of the base plate 1 to hinder the liquid backflow, so that the gas-liquid phase change can be conducted in an orderly manner, and the resistance brought by the vaporization of the working medium to the liquefied fluid can be minimized. The object of arranging multiple through holes 8 on the flow-blocking wall 7 is to allow the liquid generated by the liquefaction of the gaseous working medium in the fin 3 to enter the upper portion of the base plate 1 through the second channel 10, and then flow back to the lower portion of the base plate 1 through the through holes 8, so as to realize the gas-liquid phase equilibrium.

It should also be noted that the object of the first channel 9 and the second channel 10 which are separated from each other being formed on the clamping slot of the cover plate 2 is to realize gas-liquid separation, so that the gaseous working medium and the liquid working medium can pass through separate channels. Two open channel ports 11 are provided at positions of the fin 3 corresponding to the two channels on the clamping slot of the cover plate 2 respectively. Therefore, the flow-blocking wall 7 divides the base plate 1 into two parts and the a cyclic phase change of the working medium is performed in the two parts through four through holes 8, which effectively avoids the direct vaporization of the gas from the lower portion of the base plate 1 to the upper portion of the base plate 1, thereby avoiding affecting the thermal efficiency. When the heat source 4 is activated, the working medium passes through a steam path 19, a liquid return path 20, the through holes 8 and the steam path 19 in sequence to realize the phase-change heat exchange. The liquid working medium mainly circulates in the upper part A of the fin, and the gaseous working medium mainly circulates in the lower part B of the fin.

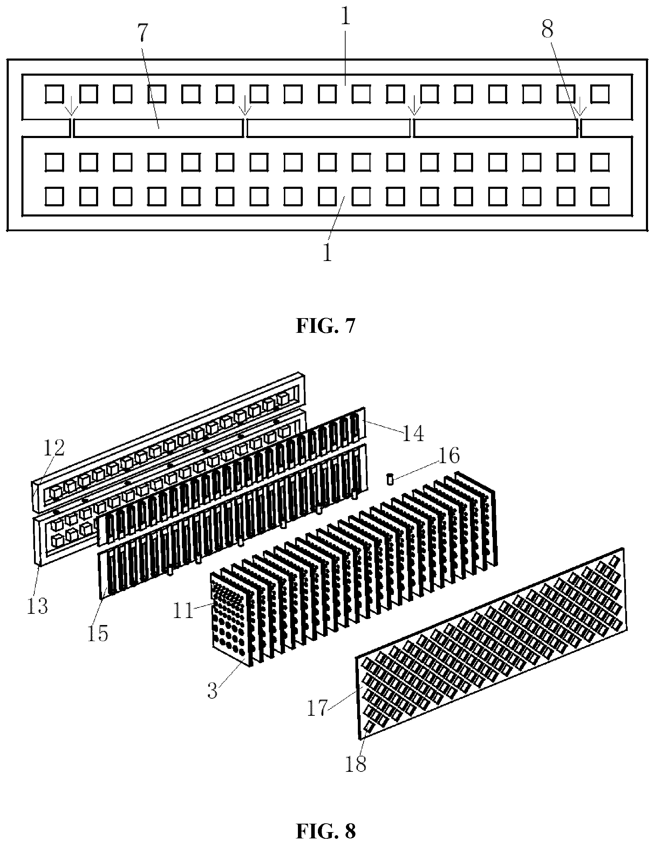

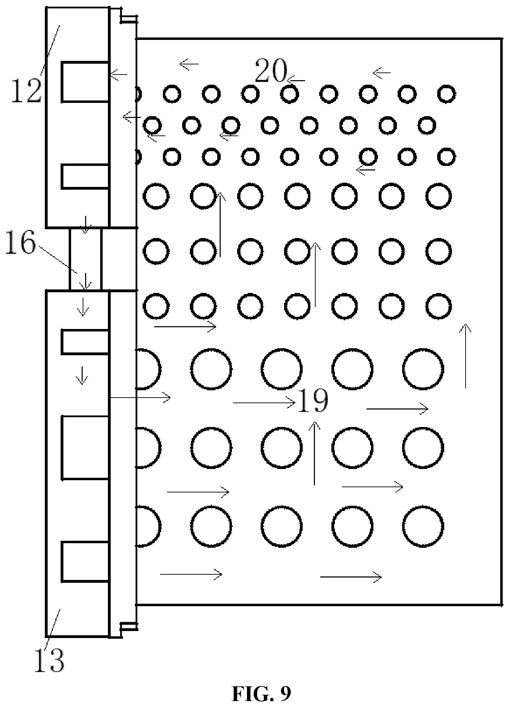

In an embodiment, the base plate 1 includes a first base body 12 and a second base body 13, and the cover plate 2 includes a first cover member 14 for circulating the liquid working medium and a second cover member 15 for circulating the gaseous working medium. The first cover member 14 is arranged corresponding to the first base body 12, and the second cover member 15 is arranged corresponding to the second base body 13. Channel ports 11 are provided at positions of the fin 3 corresponding to the first cover member 14 and the second cover member 15 respectively. The structure of the channel ports 11 are shown in FIG. 8, and the flow processes of the liquid working medium and the gaseous working medium are shown in FIG. 9, in which a flowing direction of the working medium is indicated by arrows.

It should be noted that the base plate 1 may be divided into two cavity bodies including the first base body 12 and the second base body 13, and the cover plate 2 may be divided into two members including the first cover member 14 and the second cover member 15. The vapor generated by the phase change reaction of the working medium in the first base body by absorbing heat enters the fin 3 from the second cover member 15, and the condensed liquid enters the first base body 12 through the first cover member 14. Finally, the liquid in the first base body 12 can flow back to the second base body 13, and the heat exchange will be performed repeatedly. The object of dividing the base plate 1 into two independent cavity bodies is to completely separate the gas and liquid generated by the phase change of the working medium, so as to achieve the object of long-distance transmission.

In an embodiment, the first base body 12 is connected to the second base body 13 through a pipeline 16. That is, a cavity body of the first base body 12 and a cavity body of the second base body 13 are separated from each other and connected through the pipeline 16. The gaseous working medium and the liquid working medium may operate in different cavity bodies respectively, so as to solve the heat transfer problem of the gas and the liquid in the same cavity body. The gaseous working medium is mainly in the second base body 13 and the liquid working medium is mainly in the first substrate 12, since the heat source 4 is located below the base plate 1. Therefore, there is a pressure difference between the first base body 12 and the second base body 13, so that the working medium can achieve a good phase change balance. Furthermore, the length and size of the pipeline 16 are adjustable based on the requirements for the device, so as to achieve the object of heat dissipation at a distal end.

In an embodiment, the special-shaped heat dissipation device further includes a protection plate 17, and each of the fins 3 is fixed to the protection plate 17 by welding. That is, the protection plate 17 and all of the fins 3 may be welded together, so that the heat of the fins 3 can be directly transferred to the protection plate 17. Therefore, the protection plate 17 is equivalent to an auxiliary heat dissipation plate, which can further increase the heat dissipation area of the working medium. The protection plate 17 can also protect the fins 3.

In an embodiment, multiple holes 18 are formed in the protection plate 17, and the multiple holes 18 are arranged corresponding to an interval between two adjacent fins 3. The hole 18 of the protection plate 17 may be a quadrangular hole, a pentagonal hole, a hexagonal hole or a circular hole. It can be understood that by arranging multiple holes 18 in the protection plate 17, a stack effect can be formed by the multiple holes 18 and the fins 3, so as to accelerate the convection speed of hot air.

It should be added that by using the special-shaped heat dissipation device according to the present application, the problem of the distal-end heat dissipation requirements for large-scale equipment can be solved, so that the high power consumption requirements for upgraded communication devices can be met. In addition, the product manufacturing process is mature and reliable, and it intends to be delivered in batch, so that the special-shaped heat dissipation device can not only be convenient for batch processing and manufacturing, but also can reduce the manufacturing cost of the device and ensure the product quality.

It should be noted that, as for the first channel 9 and the second channel 10 mentioned in this application document, the first and the second are only for distinguishing parts in different positions, and there is no priority among these parts.

In addition, it should be noted that, the orientation or positional relationships indicated by terms "up", "down", and the like in the present application are based on the orientation or positional relationships shown in the drawings, and are merely for the convenience of understanding the present application and the simplification of the description, and do not indicate or imply that the device or element referred to must be in a particular orientation, or be constructed and operated in a particular orientation, and therefore should not be construed as a limit to the present application.

The above embodiments in the description are described in a progressive manner. Each of the embodiments is mainly focused on describing its differences from other embodiments, and references may be made among these embodiments with respect to the same or similar parts. Any combination of all embodiments according to the present application is within the protection scope of the present application, and will not be repeated here.

The heat exchange device according to the present application is described in detail hereinbefore. Specific examples are used herein to illustrate the principle and embodiments of the present application. The description of the above embodiments is only used to facilitate understanding of the method and core concept of the present application. It should be noted that, various modifications and improvements may be made to the present application by those skilled in the art without departing from the principle of the present application, and these modifications and improvements fall within the protection scope of the present application defined by the claims.

## Claims

1. A special-shaped heat dissipation device, comprising a base plate (1), a cover plate (2) attached to the base plate (1), and a fin (3) arranged on the cover plate (2), wherein
the base plate (1) and the cover plate (2) are connected with each other to form an accommodating cavity for phase-changed working medium to flow, one side of the base plate (1) away from the cover plate (2) is configured to be connected to a heat source (4), a clamping slot is provided on one side of the cover plate (2) away from the base plate (1), the fin (3) is inserted into the clamping slot, and a gas-liquid cavity in communication with the accommodating cavity is formed in the fin;
wherein the gas-liquid cavity is internally provided with heat dissipation columns (5) with at least two different sizes, the number of the heat dissipation columns (5) with each of the at least two different sizes is plural, and the heat dissipation columns (5) with the at least two different sizes are distributed in a staggered manner as a whole.

2. The special-shaped heat dissipation device according to claim 1, wherein the heat dissipation columns (5) with the at least two different sizes gradually increase in size from a first side of the fin (3) to a second side opposite to the first side, and an interval between the heat dissipation columns (5) in two different rows gradually increase from the first side of the fin (3) to the second side opposite to the first side.

3. The special-shaped heat dissipation device according to claim 1, wherein a plurality of clamping slots are provided on one side of the cover plate (2) away from the base plate (1), and a plurality of fins (3) are correspondingly provided.

4. The special-shaped heat dissipation device according to any one of claims 1 to 3, wherein a groove is formed in the base plate (1), and a plurality of reinforcing columns (6) distributed in a matrix are arranged in the groove.

5. The special-shaped heat dissipation device according to claim 4, wherein a flow-blocking wall (7) is formed in the base plate (1), and a plurality of through holes (8) are formed in the flow-blocking wall (7); the clamping slot of the cover plate (2) is provided with a first channel (9) for circulating gaseous working medium and a second channel (10) for circulating liquid working medium, wherein the first channel (9) is arranged corresponding to a first side of the flow-blocking wall (7), the second channel (10) is arranged corresponding to a second side of the flow-blocking wall (7), and channel ports (11) are formed at positions of the fin (3) corresponding to the first channel (9) and the second channel (10) respectively.

6. The special-shaped heat dissipation device according to any one of claims 1 to 3, wherein the base plate (1) comprises a first base body (12) and a second base body (13), and the cover plate (2) comprises a first cover member (14) for circulating liquid working medium and a second cover member (15) for circulating gaseous working medium, wherein
the first cover member (14) is arranged corresponding to the first base body (12), the second cover member (15) is arranged corresponding to the second base body (13), and channel ports (11) are formed at positions of the fin (3) corresponding to the first cover member (14) and the second cover member (15) respectively.

7. The special-shaped heat dissipation device according to claim 6, wherein the first base body (12) is connected to the second base body (13) through a pipeline (16).

8. The special-shaped heat dissipation device according to claim 1, further comprising a protection plate (17), wherein the fin (3) is fixed to the protection plate (17) by welding.

9. The special-shaped heat dissipation device according to claim 8, wherein a plurality of holes (18) are formed in the protection plate (17), wherein
each of the plurality of holes (18) is a regular quadrangular hole, a regular pentagonal hole, a regular hexagonal hole, or a circular hole.

10. The special-shaped heat dissipation device according to claim 1, wherein the base plate (1), the cover plate (2) and the fin (3) are formed to be an integrated brazed structural member; and wherein
each of the heat dissipation columns (5) is a cylinder, a regular triangular column, a regular quadrangular column, a regular pentagonal column, or a regular hexagonal column.
